# EUROPÄISCHE PATENTSCHRIFT

(11) **EP 1 472 732 B1**
(45) Veröffentlichungstag und Bekanntmachung des Hinweises auf die Patenterteilung: **15.11.2006**
(21) Anmeldenummer: 03737268.7
(22) Anmeldetag: 23.01.2003
(51) Int. Cl.: H01L 23/50, H01L 23/66

(54) **VORRICHTUNG ZUR VERBINDUNG EINES IC-ANSCHLUSSES MIT EINEM BEZUGSPOTENTIAL**
DEVICE FOR CONNECTING AN IC TERMINAL TO A REFERENCE POTENTIAL
DISPOSITIF POUR RELIER UNE BORNE DE CIRCUIT INTEGRE A UN POTENTIEL DE REFERENCE

(30) Priorität: 04.02.2002 DE 10204403
(43) Veröffentlichungstag der Anmeldung: 03.11.2004
(73) Patentinhaber: Infineon Technologies AG, 81669 München (DE)
(72) Erfinder: FORSTNER, Johann-Peter, 85643 Steinhöring (DE); WEBER, Stephan, 81739 München (DE)
(74) Vertreter: Schoppe, Fritz
(86) Internationale Anmeldenummer: PCT/EP2003/000682
(87) Internationale Veröffentlichungsnummer: WO 2003/067659

(56) Entgegenhaltungen:
- EP-A- 0 851 492
- US-A- 5 406 114
- US-A- 6 034 415
- US-B1- 6 190 978

## Beschreibung

Die vorliegende Erfindung bezieht sich auf eine Vorrichtung zur Verbindung eines IC-Anschlusses mit einem Bezugspotential, und insbesondere eine solche Vorrichtung, die sich zur Verbindung eines IC-Anschlusses mit einem Massepotential eignet.

Bei einer Vielzahl von integrierten Schaltungen (IC; IC = integrated circuit), beispielsweise elektronischen Verstärkerstufen, hängt die Leistungsfähigkeit häufig von der Masseverbindung der aktiven Elemente ab. Dies trifft insbesondere bei hohen Frequenzen zu. Beispielsweise führt bei einer häufig verwendeten Emitterschaltung einer elektronischen Verstärkerstufe eine zu hochohmige Verbindung des Emitters nach Masse zu einem Verstärkungs- und Wirkungsgrad-Abfall.

Im Stand der Technik ist eine Vielzahl von Techniken bekannt, um Anschlußflächen eines Schaltungschips (IC-Chip) mit einem externen Bezugspotential zu verbinden.

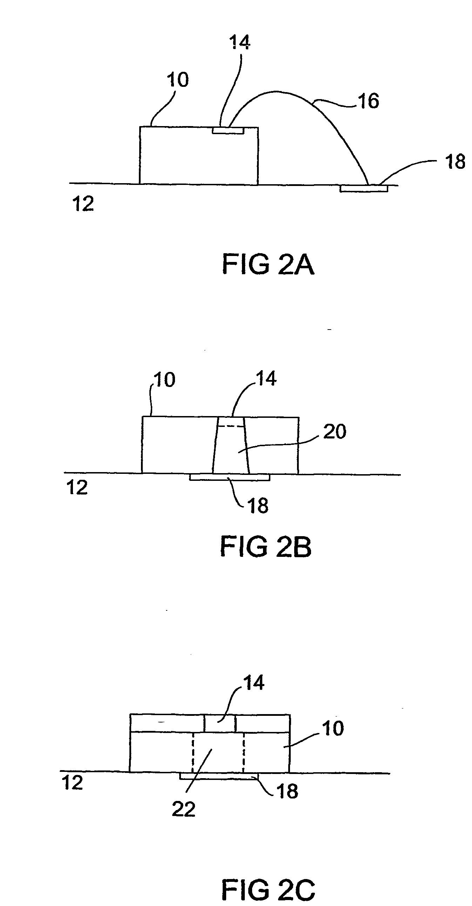

Eine häufig verwendete bekannte Technik besteht darin, die Masse-Anschlußflächen eines IC-Chips unter Verwendung von Bonddrähten mit leitfähigen Bereichen auf einem Substrat, auf dem der IC-Chip angeordnet ist, zu verbinden, wobei die leitfähigen Bereiche ein Massepotential definieren. Ein Beispiel einer solchen Verbindung ist in Fig. 2a gezeigt, in der ein integrierter Schaltungschip (IC-Chip) 10, der auf einem Substrat 12, bei dem es sich beispielsweise um eine Mehrschichtplatine handeln kann, angeordnet ist. Ein Masseanschluß 14 des IC-Chips ist unter Verwendung eines Bonddrahts 16 mit einer Substratmassefläche 18 elektrisch leitfähig verbunden.

Bonddrähte besitzen jedoch eine recht hohe Induktivität, so daß eine Masseverbindung, wie sie in Fig. 2a gezeigt ist, schlechte Hochfrequenzeigenschaften nach sich zieht. Zur Induktivitätsreduzierung ist es zwar möglich, mehrere Bonddrähte parallel zu schalten, wobei dann jedoch der Platzbedarf zunimmt.

In Fig. 2b ist eine alternative, nach dem Stand der Technik verwendete Technik, um eine Anschlußfläche 14 eines Chips 10 mit einer Substratmassefläche 18 zu verbinden, gezeigt. Dabei handelt es sich um einen Chip durch Kontaktierung, d. h. einen Chip-Via 20 aus Metall, der durch den Chip 10 verläuft und eine direkte metallische Verbindung zwischen dem Masseanschluß 14 und der Substratmassefläche 18 darstellt. Die Erzeugung von Chip-Vias erhöht jedoch die Komplexität des Herstellungsprozesses erheblich, insbesondere hinsichtlich eines erforderlichen Dünn-Schleifens, Ätzens oder Bohrens. Darüber hinaus existiert eine Bruchgefahr während einer derartigen Herstellung von Chip-Vias.

Schließlich ist es aus dem Stand der Technik bekannt, statt der Metalldurchkontaktierungen solche aus hochdotiertem Silizium zu verwenden, die als Sinker bezeichnet werden. Ein solcher Sinker 22, der einen Masseanschluß 14 eines IC-Chips 10 mit einer Substratmassefläche 18 verbindet, ist in Fig. 2c schematisch gezeigt. Zur Herstellung einer solchen Durchkontaktierung aus hochdotiertem Silizium sind weniger Prozeßschritte nötig als zur Herstellung eines Metall-Chip-Vias. Jedoch ist die Verbindung aus hochdotiertem Silizium deutlich hochohmiger, was z.B. bei Leistungsverstärkern den Wirkungsgrad reduziert. Beide Via-Arten, d.h. Metall oder hochdotiertes Silizium, sind jedoch bezüglich der Induktivität circa eine Größenordnung günstiger als eine Masseverbindung unter Verwendung eines Bonddrahts, wie sie oben Bezug nehmend auf Fig. 2a erläutert wurde.

Die Aufgabe der vorliegenden Erfindung besteht darin, eine Vorrichtung zur Verbindung eines IC-Anschlusses mit einem Bezugspotential zu schaffen, die ein verbessertes Betriebsverhalten der IC ermöglicht.

Diese Aufgabe wird durch eine Vorrichtung nach Anspruch 1 gelöst.

Die vorliegende Erfindung schafft eine Vorrichtung zur elektrisch leitfähigen Verbindung eines Anschlusses eines Schaltungschips mit einem externen Bezugspotential, wobei die Vorrichtung eine Parallelschaltung aus einem Bonddraht und einem dotiertem Halbleitermaterial aufweist.

Das dotierte Halbleitermaterial kann in der Form herkömmlicher Sinker, d.h. Durchkontaktierungen aus einem dotiertem Halbleitermaterial, gebildet sein. Typische Dotierungen liegen in einem Bereich von 10¹⁸ cm⁻³ bis 4·10²⁰ cm⁻³, und insbesondere in einem Bereich von 10¹⁹ cm⁻³ bis 1·10²⁰cm⁻³.

Die vorliegende Erfindung basiert auf der Erkenntnis, daß bei vielen Anwendungen die bekannten Masseverbindungen nicht optimal sind, da zum einen die Induktivität der Bonddrähte erheblich stört und zum anderen auch Sinker aus hochdotiertem Halbleitermaterial, beispielsweise Silizium, wegen der ohmschen Verluste nicht optimal sind. Erfindungsgemäß werden durch die Parallelschaltung des verlustbehafteten Sinkers mit dem Bonddraht die Nachteile beider eben genannten Verbindungsarten eliminiert, ohne daß der Herstellungsprozeß übermäßig komplizierter gestaltet wird. Bei der Parallelschaltung aus Sinker und Bonddraht fließt ein Hochfrequenzstrom überwiegend über den Sinker, während ein Niederfrequenzstrom und insbesondere ein Gleichstrom über den Bonddraht oder die Bonddrähte fließt.

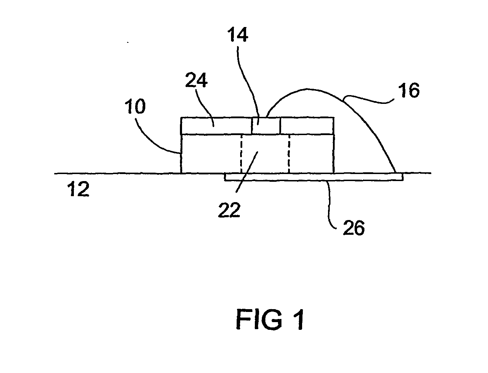

Ein bevorzugtes Ausführungsbeispiel der vorliegenden Erfindung wird nachfolgend Bezug nehmend auf Fig. 1 näher erläutert. Es zeigt:
- Fig. 1: eine schematische Darstellung eines Ausführungsbeispiels einer erfindungsgemäßen Vorrichtung.

In Fig. 1 ist ein IC-Chip 10, der auf einem Substrat 12 angebracht ist. Der IC-Chip 10 umfaßt einen Masseanschluß 14, bei dem es sich um eine auf dem IC-Chip 10 angeordnete metallische Anschlußfläche (Pad) handeln kann. Ferner umfaßt der Schaltungschip 10 aktive Bereiche 16, die in der Regel in von dem Substrat 12 abgewandten Bereichen der Schaltungschips 10 gebildet sind.

Der IC-Chip 10 umfaßt ferner einen Sinker 22, der den Masseanschluß 14 mit einer Substratmassefläche 26 elektrisch leitfähig verbindet. Darüber hinaus ist die Substratmassefläche 26 über einen Bonddraht 16 elektrisch leitfähig mit dem Masseanschluß 14 des IC-Chips 10 verbunden.

Der Sinker 22 kann durch hochdotierte Bereiche in einem ansonsten niedriger dotierten Chipsubstrat gebildet sein. Dabei handelt es sich um ein dotiertes Halbleitermaterial eines Dotierungstyps, das zwischen dem Masseanschluß des IC-Chips und der Substratmassefläche angeordnet ist, so dass kein PN-Übergang zwischen denselben vorliegt. Typische Dotierungshöhen können in einem Bereich zwischen 10¹⁸ cm⁻³ bis 4·10²⁰ cm⁻³ liegen, während bevorzugte Dotierungshöhen in einem Bereich von 10¹⁹ cm⁻³ bis 10²⁰cm⁻³ liegen. Die angegebenen Dotierungsbereiche sind vorteilhaft, da bei höheren Dotierungen Kristallfehler und die erforderliche Prozesszeit zunehmen, während bei niedrigeren Dotierungen die Leitfähigkeit abnimmt.

Bei bevorzugten Ausführungsbeispielen der vorliegenden Erfindung kann der Sinker aus hochdotiertem Silizium nicht durch das ganze Substrat, das eine Dicke von etwa 100 bis 300 µm aufweisen kann, reichen, sondern erstreckt sich nur über einen Bereich von beispielsweise 3 bis 10 µm, da sonst die Prozesszeiten zu lang werden und bei hohen Dotierungen Kristallfehler auftreten können. Der Rest des Weges, d.h. des Abstands zwischen Masseanschluß auf dem Chip und Substratmassefläche ist durch ein einheitlich (über den ganzen Wafer) hochdotiertes Siliziumsubstrat gebildet, das eine typische Leitfähigkeit von 1 ... 10 mΩ·cm aufweisen kann. Nur dort wo ein Masseanschluß benötigt wird, wird dann selektiv ein Sinker hergestellt, um die Verbindung durch die niedrig dotierten Substratbereiche einer Dicke von beispielsweise 3 bis 10 µm zu implementieren.

Alternativ kann das gesamte Chipsubstrat mit Ausnahme der Sinker 22 undotiert bzw. deutlich niedriger dotiert sein.

Der Sinker 22 und der Bonddraht 16 sind mit der gleichen Substratmassefläche 26 verbunden. Alternativ können der Sinker 22 und der Bonddraht 16 mit unterschiedlichen Substratanschlußflächen verbunden sein, solange diese auf einem gleichen Bezugspotential liegen.

Durch die erfindungsgemäße Parallelschaltung von dotiertem Halbleitermaterial und Bonddraht zwischen einem Chip-Anschluß und einer externen Anschlußfläche, die auf einem Bezugspotential liegt, wird eine "breitbandige" Verbindung erzeugt, da ein Hochfrequenzstrom überwiegend über das dotierte Halbleitermaterial fließen kann, während ein Niederfrequenzstrom und insbesondere ein Gleichstrom über den Bonddraht oder die Bonddrähte, falls mehrere Bonddrähte zwischen Chip-Anschluß und externer Anschlußfläche vorgesehen sind, fließen kann.

Die erfindungsgemäße Vorrichtung eignet sich insbesondere zur Erzeugung einer Masseverbindung der aktiven Elemente von elektronischen Verstärkerstufen mit einer äußeren Masseebene. Insbesondere ist die vorliegende Erfindung vorteilhaft einsetzbar, um bei der häufig verwendeten Emitterschaltung eine Masseverbindung des Emitters mit einer externen Massefläche zu ermöglichen. Unter externer Massefläche wird dabei eine Massefläche, die nicht Bestandteil des IC-Chips selbst ist, verstanden. Somit können Verstärkungsabfälle und Wirkungsgradabfälle elektronischer Verstärkerstufen insbesondere bei hohen Frequenzen reduziert bzw. vermieden werden.

### Bezugszeichenliste

- 10: IC-Chip
- 12: Substrat
- 14: Masseanschluß
- 16: Bonddraht
- 18: Substratmassefläche
- 20: Chip-Via
- 22: Sinker
- 24: Aktive Bereiche
- 26: Substratmassefläche

## Patentansprüche

1. Schaltungschip (10) mit einer Vorrichtung zur elektrisch leitfähigen Verbindung eines Anschlusses (14) desselben mit einem externen Bezugspotential (26), **dadurch gekennzeichnet, daß** die Vorrichtung eine Parallelschaltung aus einem Bonddraht (16) und einem in einem Substrat des Schaltungschips (10) gebildeten Halbleiterbereich (22), der höher dotiert ist als das Substrat des Schaltungschips (10), aufweist.

2. Schaltungschip nach Anspruch 1, bei dem das dotierte Halbleitermaterial Silizium ist.

3. Schaltungschip nach Anspruch 1 oder 2, bei dem das dotierte Halbleitermaterial (22) einen dotierten Bereich eines Dotierungstyps zwischen dem Anschluß des Schaltungschips (14) und dem Bezugspotential (26), der sich durch den Schaltungschip (10) erstreckt, aufweist.

4. Schaltungschip nach einem der Ansprüche 1 bis 3, bei dem der Schaltungschip eine Verstärkerstufe ist.

5. Schaltungschip nach Anspruch 4, bei dem der Anschluß (14) ein Emitteranschluß der Verstärkerstufe ist.

6. Schaltungschip nach einem der Ansprüche 1 bis 5, bei dem das Bezugspotential (26) durch einen leitfähigen Bereich auf einem Substrat (12) gebildet ist.

7. Schaltungschip nach einem der Ansprüche 1 bis 6, bei dem das dotierte Halbleitermaterial (22) einen Sinker aufweist.

8. Schaltungschip nach einem der Ansprüche 1 bis 7, bei dem das Bezugspotential (26) ein Massepotential ist.

## Claims

1. Circuit chip (10) having an apparatus for an electrically conductive connection of a terminal (14) thereof to an external reference potential (26), **characterized in that** the apparatus comprises a parallel connection of a bonding wire (16) and a semiconductor area (22) formed in a substrate of the circuit chip (10), which is doped higher than the substrate of the circuit chip (10).

2. Circuit chip according to claim 1, wherein the doped semiconductor material is silicon.

3. Circuit chip according to claim 1 or 2, wherein the doped semiconductor material (22) has a doped area of a doping type between the terminal of the circuit chip (14) and the reference potential (26), which extends through the circuit chip (10).

4. Circuit chip according to one of claims 1 to 3, wherein the circuit chip is an amplifier stage.

5. Circuit chip according to claim 4, wherein the terminal (14) is an emitter terminal of the amplifier stage.

6. Circuit chip according to one of claims 1 to 5, wherein the reference potential (26) is formed by a conductive area on a substrate (12).

7. Circuit chip according to one of claims 1 to 6, wherein the doped semiconductor material (22) comprises a sinker.

8. Circuit chip according to one of claims 1 to 7, wherein the reference potential (26) is a ground potential.

## Revendications

1. Puce de commutation (10) avec un dispositif destiné à relier de manière électriquement conductrice une connexion (14) de cette dernière à un potentiel de référence externe (26), **caractérisée par le fait que** le dispositif présente un circuit parallèle composé d'un fil d'assemblage (16) et d'une zone à semi-conducteur (22) formée dans un substrat de la puce de commutation (10) qui est dopée plus fortement que le substrat de puce de commutation (10).

2. Puce de commutation selon la revendication 1, dans lequel le matériau semi-conducteur dopé est du silicium.

3. Puce de commutation selon la revendication 1 ou 2, dans lequel le matériau semi-conducteur dopé (22) présente une zone dopée d'un type de dopage entre la connexion de la puce de commutation (14) et le potentiel de référence (26) qui s'étend sur toute la puce de commutation (10).

4. Puce de commutation selon l'une des revendications 1 à 3, dans lequel la puce de commutation est un étage amplificateur.

5. Puce de commutation selon la revendication 4, dans lequel la connexion (14) est une connexion d'émetteur de l'étage amplificateur.

6. Puce de commutation selon l'une des revendications 1 à 5, dans lequel le potentiel de référence (26) est formé par une zone conductrice sur un substrat (12).

7. Puce de commutation selon l'une des revendications 1 à 6, dans lequel le matériau semi-conducteur dopé (22) présente un lest.

8. Puce de commutation selon l'une des revendications 1 à 7, dans lequel le potentiel de référence (26) est un potentiel de masse.
